Europäisches Patentamt

European Patent Office

Office européen des brevets

(11) Publication number: **0 338 213**
**A2**

## (12) EUROPEAN PATENT APPLICATION

(21) Application number: **89103083.5**

(22) Date of filing: **22.02.89**

(51) Int. Cl.⁴: **H01L 23/06 , H01L 23/14**

The title of the invention has been amended (Guidelines for Examination in the EPO, A-III, 7.3).

(30) Priority: **22.02.88 JP 39034/88**

(43) Date of publication of application:
**25.10.89 Bulletin 89/43**

(84) Designated Contracting States:
**DE FR GB IT**

(71) Applicant: **KABUSHIKI KAISHA TOSHIBA**
**72, Horikawa-cho Saiwai-ku**
**Kawasaki-shi Kanagawa-ken 210(JP)**

Applicant: **TOSHIBA MICRO-COMPUTER**
**ENGINEERING CORPORATION**
**25-1, Ekimae-hon-cho Kawasaki-ku**
**Kawasaki-shi Kanagawa-ken(JP)**

(72) Inventor: **Shindo, Masamichi**
**56, Zenbu-cho Asahi-ku**
**Yokohama-shi Kanagawa-ken(JP)**
Inventor: **Sakurai, Toshiharu**
**622, Co-op Nomura 250-1, Shimo-Kurata-Cho**
**Totsuka-Ku Yokohama-Shi**
**Kanagawa-Ken(JP)**
Inventor: **Taguchi, Hideo 530, Toshiba**
**Shinkoyasu Ryo**
**2-14-10, Shinkoyasu Kanagawa-Ku**
**Yokohama-Shi Kanagawa-Ken(JP)**
Inventor: **Izawa, Nobu C531, Toshiba Isogo**
**Dairoku Ryo**
**2-8-2, Shiomidai Isogo-Ku**
**Yokohama-Shi Kanagawa-Ken(JP)**
Inventor: **Ohno, Jun-ichi**
**1-24-24, Nagata-Higashi Minami-Ku**
**Yokohama-Shi Kanagawa-Ken(JP)**
Inventor: **Takase, Hiroyuki**
**2-27-10-1051, Urakamidai**
**Yokosuka-Shi Kanagawa-Ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Semiconductor device with a metal package.**

(57) A semiconductor chip (3) is mounted on the upper surface of a metal package base (1), the space region above the semiconductor chip is covered and air-tightly sealed by a metal cover plate.
An electrically insulating layer (13,15) is pro-vided on the bottom surface of the package base and/or entire outer surface of the metal cover.

F I G. 1

## Semiconductor Device

### BACKGROUND OF THE INVENTION

#### Technical Field

The present invention relates to a semiconductor device and more particularly to a semiconductor device in which a metal package base is covered with a metal cover plate.

#### Background Art

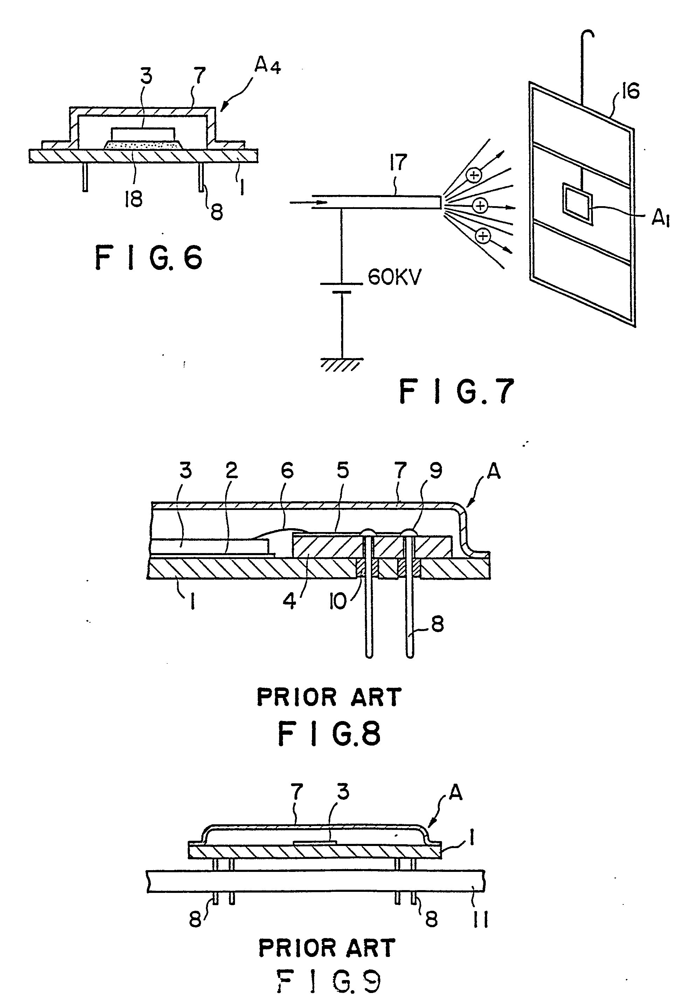

Until recently, semiconductor devices have been packed in packages made of ceramics and plastics, but recently they are also covered with metal cover plates as illustrated in FIG. 8. In the conventional semiconductor device shown in FIG. 8, a semiconductor chip 3 is mounted over an intervening silver paste 2 substantially at the center portion of a package base 1, and the electrodes of the semiconductor chip 3 are electrically connected through bonding wires to wires 5 printed over the upper surface of a printed-circuit board 4 disposed so as to surround the semiconductor chip 3. The upper portions above the semiconductor chip 3 and the board 4 are covered with a metal cover plate 7, and the upper ends of lead pins 8 which are extended through the package base 1 and downwardly are connected to the wires 5, respectively, with solder 9. The space between each lead pin 8 and the inner wall surface of each lead pin hole is sealed with a sealing material 10 such as glass.

However, in the case of the semiconductor device described above, since the package base 1 and the cover plate 7 are made of an electrically conductive metal, the potential of the package base 1 and the cover plate 7 as well as the bottom surface of the semiconductor chip 3 becomes equal to the potential around the semiconductor device generally indicated by A. That is, when the semiconductor device A is mounted on a printed-circuit board 11 as shown in FIG. 9, the semiconductor chip 3 essentially operates only in response to the potentials applied through the lead pins 8. However, when the package base 1 and the printed-circuit board 11 are electrically interconnected with each other, a path (1) is established from the printed circuit board 11 through the silver paste 2 to the semiconductor chip 3. Furthermore, when the metal cover plate 7 is electrically connected to a peripheral wire around the semiconductor device A, another path (2) is established from the peripheral wire through the metal cover plate 7, the package base 1 and the silver paste 2 to the semiconductor chip 3. As a result, undesired voltages are applied to the semiconductor chip 3 from the paths (1) and (2). As a consequence, adverse phenomena such as latch-up, electrostatic destruction (ESD) and so on occur, leading a breakdown of the semiconductor chip 3.

### SUMMARY OF THE INVENTION

Accordingly, an object of the present invention is to provide a semiconductor device which is of unitary construction and can positively prevent adverse effect on a semiconductor chip due to the peripheral conditions around a metal semiconductor package.

To the above and other ends, according to the present invention, a semiconductor chip is mounted on the upper surface of a metal package base; the space region above the semiconductor chip is covered and air-tightly sealed by a metal cover plate; and an insulator is attached to the bottom surface of the package base.

Furthermore, according to another embodiment, a semiconductor chip is mounted on the upper surface of a metal package base; the upper portion of the semiconductor chip is covered and air-tightly sealed by a metal cover plate; and the bottom surface of the package base and the entire surface of the metal cover are coated with an electrically insulating compound.

According to a further embodiment of the present invention, a semiconductor chip is mounted over an electrically insulating adhesive on the upper surface of a metal package base; and the upper portion of the semiconductor chip is covered and air-tightly sealed by a metal cover plate.

In the case of the semiconductor device in which the insulator is attached to the bottom surface of the package base as described above, the package base and a printed-circuit board or the like upon which is mounted the semiconductor device can be electrically isolated from each other by the electric insulator so as to close the above mentioned path (1) extending from the printed-circuit board or the like to the bottom surface of the semiconductor chip.

When the entire surface of the metal cover plate is coated with an electrically insulating compound, even when the metal cover plate contacts a peripheral wire or the like, they can be electrically isolated from each other so as to close the above mentioned path (2) extending from the peripheral wire or the like through the metal cover plate to the bottom surface of the semiconductor chip.

Furthermore, in the case of the semiconductor device of the type in which the semiconductor chip is mounted over an interposed electrically insulative adhesive on the upper surface of the package base, the package base and the semiconductor chip can be electrically isolated from each other.

It follows therefore that the present invention can prevent adverse phenomena such as latch-up, electrostatic destruction and so on caused by the adverse effect of the application of voltages through the unexpected pathes and consequently can positively prevent breakdown of the semiconductor chip.

Furthermore, according to the present invention, when the semiconductor devices are mounted, the use of spacers can be eliminated so that the mounting of the semiconductor devices can be carried out in a simple manner. In addition, the semiconductor devices and the printed-circuit boards or the like upon which the semiconductor device are mounted can be spaced apart from each other by a suitable distance.

Moreover, the present invention affords an anticorrosion effect by coating the bottom surface of the package base and the entire outer surface of the metal cover.

## BRIEF DESCRIPTION OF THE DRAWINGS

In the drawings:

FIG. 1 is a partial sectional side view of a first preferred embodiment of the present invention illustrating the essential details of construction;

FIG. 2 is a sectional side view illustrating the construction of the entire device of the first preferred embodiment;

FIG. 3 is a plan view showing a glass-epoxy

FIGS. 4, 5 and 6 are sectional side views illustrating second, third and fourth preferred embodiments, respectively, of the present invention;

FIG. 7 is a schematic perspective view indicating an electrostatic particle spraying process;

FIG. 8 is a partial sectional side view illustrating the essential details of a conventional semiconductor device; and

FIG. 9 is a sectional side view of the same device mounted on a printed circuit board.

## DETAILED DESCRIPTION OF THE PREFERRED EMBODIMENTS

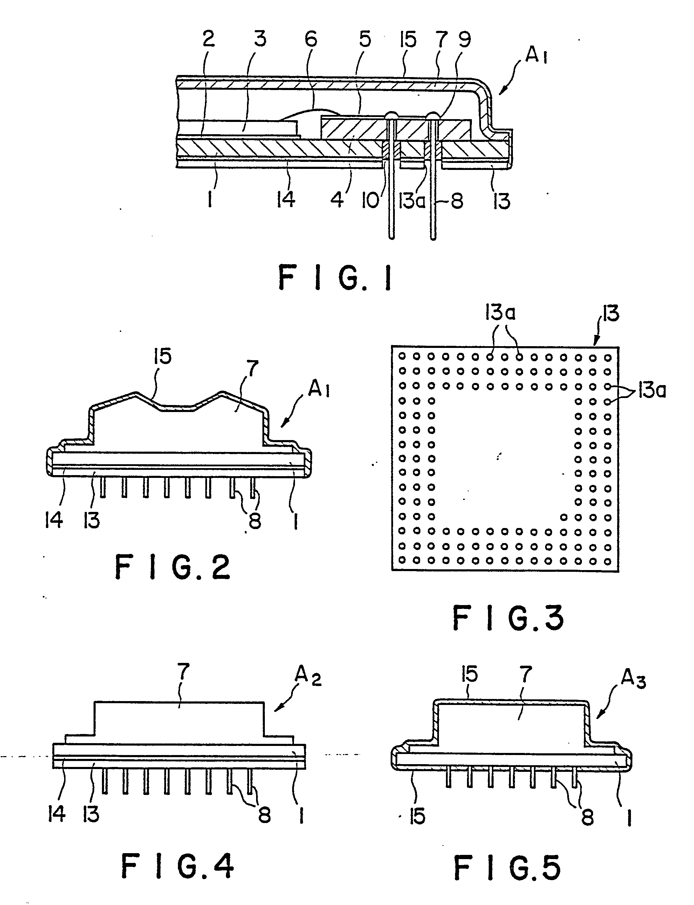

First Embodiment, FIGS. 1, 2, and 3

Referring now to FIGS. 1 to 3, a first embodiment of the present invention will be described. A semiconductor chip 3 is mounted over an interposed silver paste 2 at substantially the center portion of a rectangular metal package base 1. The electrodes of the semiconductor chip 3 are connected through bonding wires 6 to their corresponding wires 5 printed over the surface of a printed-wire board 4 disposed so as to surround the semiconductor chip 3. The space above the semiconductor chip 3 and the board 4 is covered and hermetically sealed by a metal cover plate 7. Lead pins 8 are extended through the package base 1 and downwardly beyond the bottom surface thereof and their upper ends are connected to their corresponding wires 5 with solder 9. The annular space between each lead pin 8 and the inner wall surface of each lead-pin hole is sealed with a sealing material 10 such as glass. Attached to the bottom surface of the package base 1 with an epoxy resin adhesive is a base plate 13 comprising a glass screen which is an electrically insulator member and is impregnated with an epoxy resin.

The epoxy-impregnated glass screen board 13 is formed with a plurality of through holes 13a at respective positions corresponding to the lead pins 8 as shown in FIG. 3.

Instead of the epoxy-impregnated glass base plate 13 which is an insulator, a crepe paper mica, a silicone rubber or the like may be used. Furthermore, as an adhesive 14, in addition to the above-described epoxy resin adhesive, a novolak adhesive, a siliconeadhesive, a varnish adhesive and so on may be used.

Furthermore, an insulating coating 15 comprising electrically insulating particles or liquid is applied over the entire surface of the metal cover plate 7. Thus, the semiconductor device $A_1$ is obtained.

The above mentioned coating particles are, for instance, those of an epoxy resin, and the liquid coating material is, for instance, one of varnish-epoxy series.

In the case of spraying the insulating coating 15, for instance, as shown in FIG. 7, a so-called electrostatic coating is used. That is, the semiconductor device $A_1$ is suspended from a metal frame 16 which is a cathode and is grounded and a coating material such as an epoxy resin is used as an anode. A voltage of the order of 60 KV is applied to a spray gun 17 so as to spray the coating material over the entire surface of the metal cover plate 7, thereby coating the latter with the insulating material.

The electrically insulating epoxy-impregnated glass base plate 13 is attached to the bottom surface of the package base 1 so that the package base 1 and the printed circuit board 11 upon which the semiconductor device A₁ is mounted can be electrically isolated from each other (FIG. 10) so that the path (1) extending from the printed-circuit board 11 to the bottom surface of the semiconductor chip 3 can be completely cut off. Since the entire surface of the metal cover plate 7 is coated with an electrically insulating coating material, even if the metal cover plate 7 should contact a peripheral wire, they are completely electrically isolated from each other. As a result, the path (2) extending from the peripheral wire in contact with the metal cover plate 7 to the bottom surface of the semiconductor chip 3 can be also completely closed.

## Second Embodiment, FIG. 4

In a second embodiment of the present invention shown in FIG. 4, the coating of the entire surface of the metal cover plate 7 with the electrically insulating coating material 15 is eliminated in the case of the fabrication of a semiconductor device A₂ so that the package base 1 and the printed-circuit board 11 (FIG> 10) can be completely electrically isolated from each other.

## Third Embodiment, FIG. 5

In a third embodiment of the present invention shown in FIG. 5, the electrically insulating coating material 15 is sprayed by the electrostatic coating process over the bottom surface of the package base 1 and the entire surface of the metal cover plate 7 in the case of the fabrication of a semiconductor device A₃.

## Fourth Embodiment, FIG. 6

In a fourth embodiment of the present invention shown in FIG. 6, the bottom surface of the package base 1 and the entire surface of the metal cover plate 7 are not coated with an electrically insulating coating material, but the semiconductor chip 3 is mounted over all intervening electrically insulating adhesive 18 on the upper surface of the package base 1 in the case of the fabrication of a semiconductor device A₄. Therefore the package base 1 and the semiconductor chip 3 are completely electrically isolated from each other so that the bottom surface of the semiconductor chip 3 and the package base 1 are prevented from being at the same potential.

The insulating adhesive 18 is, for instance, an epoxy resin. In the case of this epoxy-series resin, it is preferable to admix therewith a filler ($SiO_2$ or the like) in excess of about 30 microns in order to maintain stable electrical isolation. In this case, the insulation resistance between the semiconductor device A₄ and the package base 1 can be maintained at less than 10 MΩ until the applied voltage reaches 100 V.

## Claims

1. A semiconductor device in which a metal package base is covered with a metal cover plate characterized in that it comprises:
a metal package base;
a semiconductor chip mounted on the upper surface of said package base;
a metal cover plate covering and air-tightly sealing and
an insulator attached to the bottom surface of said package base.

2. A semiconductor device in which a metal package base is covered with a metal cover plate characterized in that it comprises:
a metal package base;
semiconductor chip mounted on the upper surface of said package base;
a metal cover plate covering and air-tightly sealing; and
an electrically insulating compound coating the bottom surface of said package base and the entire outer surface of said metal cover plate.

3. A semiconductor device in which a metal package base is covered with a metal cover plate characterized in that it comprises:
a metal package base;
a semiconductor chip mounted over an interposed electrically insulating adhesive on the upper surface of said package base; and
a metal cover plate covering and air-tightly sealing.

F I G. 1

F I G. 2

F I G.3

F I G.4

F I G.5

FIG.6

FIG.7

3 2 6 5 7 9 A

PRIOR ART
FIG.8

PRIOR ART
FIG.9